# EUROPEAN PATENT APPLICATION

(11) **EP 4 741 673 A1**
(43) Date of publication of application: **13.05.2026**
(21) Application number: 25215096.6
(22) Date of filing: 11.11.2025
(51) Int. Cl.: F16C 17/26, F04D 29/051, F16C 32/04, H02K 7/09, F16C 17/24, F16C 17/02

(54) **BEARING DEVICE, MOTOR AND COMPRESSOR**

(30) Priority: 12.11.2024 CN 202411611847
(71) Applicant: Carrier Corporation, Palm Beach Gardens, FL 33418 (US)
(72) Inventor: YU, Hao, Shanghai, 201206 (CN); CAO, Chong, Shanghai, 201206 (CN); LI, Jiedong, Shanghai, 201206 (CN); ZHANG, Zhenyu, Shanghai, 201206 (CN)
(74) Representative: Dehns

(57) **Abstract**

This application provides a bearing device (1), and a motor (2) and a compressor (3) including the bearing device (1). The bearing device (1) includes a rotating shaft (101), a first bearing (102) and a second bearing (103) disposed around the rotating shaft (101) and parallel to each other, a thrust disc (104) sleeved on and fixed to the rotating shaft (101), and a sensor disc (105) disposed around the rotating shaft (101) and parallel to the thrust disc (104). A first displacement sensor (106) including a first sensor probe (1051) and a second displacement sensor (107) including a second sensor probe (1052) are symmetrically disposed on the sensor disc (105). By connecting the first displacement sensor (106), the second displacement sensor (107), and an excitation source module (108, 109, 110) in parallel or in series, detection results of the first sensor probe (1051) and the second sensor probe (1052) are combined to obtain a degree of deviation of the rotating shaft (101), which avoids an error in the parallelism that may occur when one displacement sensor or one sensor probe is used alone.

## Description

### PRIORITY CLAIM

This application claims benefit of Chinese Patent Application No. 202411611847.3, filed November 12, 2024, and all the benefits accruing therefrom under 35 U.S.C. §119, the contents of which in their entirety are herein incorporated by reference.

### BACKGROUND

This application relates to the technical field of refrigeration/cooling equipment, and in particular to a bearing device, and a motor and a compressor using the bearing device.

A bearing device is a key component in machinery for supporting and guiding a rotating or reciprocating component. The bearing device can reduce friction and improve mechanical efficiency and stability. A thrust bearing is a mechanical bearing specially configured to bear an axial load (that is, a load in an axial direction). Unlike other types of bearings, the thrust bearing is mainly used to handle an axial force to support stable operation of a rotating component.

The thrust bearing is provided with a thrust disc and a sensor disc surrounding a rotating shaft, and the thrust disc and the sensor disc are generally arranged in parallel. However, in a process of motor manufacturing, rotor manufacturing or assembly, and the like, some errors may occur in the thrust disc and the sensor disc when the rotating shaft rotates, thereby affecting the parallelism between the thrust disc and the sensor disc. The error in the parallelism may bring a rotating co-frequency vibration signal to a control system, which affects the control performance.

### SUMMARY

An object of this application is to provide a bearing device, and a motor and a compressor using the bearing device to at least solve or alleviate some problems existing in the related art.

According to a first aspect of the invention there is provided a bearing device, including: a rotating shaft; a first bearing surrounding the rotating shaft; a second bearing surrounding the rotating shaft in parallel with the first bearing; a thrust disc sleeved on and fixed to the rotating shaft between the first bearing and the second bearing; a sensor disc disposed around the rotating shaft between the first bearing and the thrust disc or between the second bearing and the thrust disc; a first displacement sensor including a first sensor probe disposed on the sensor disc; and a second displacement sensor including a second sensor probe disposed on the sensor disc symmetrically with respect to the first sensor probe.

The bearing device may include: a first excitation source module electrically connected to the first sensor probe; and a second excitation source module electrically connected to the second sensor probe.

The bearing device may include an excitation source module electrically connected in series with the first sensor probe and the second sensor probe.

The bearing device may include: a third sensor probe disposed on the sensor disc; and a fourth sensor probe disposed on the sensor disc symmetrically with respect to the third sensor probe, in which the excitation source module is electrically connected in series with the first sensor probe, the second sensor probe, the third sensor probe, and the fourth sensor probe.

The first excitation source module and the first sensor probe may be electrically connected by a coaxial cable, and the second excitation source module and the second sensor probe may be electrically connected by a coaxial cable.

The excitation source module may be electrically connected in series with the first sensor probe and the second sensor probe by a coaxial cable, or the excitation source module may be electrically connected in series with the first sensor probe, the second sensor probe, the third sensor probe, and the fourth sensor probe by a coaxial cable.

The first displacement sensor probe, the second displacement sensor probe, the third displacement sensor probe, and the fourth displacement sensor probe may each be an inductive sensor probe including a core and a coil.

The first sensor probe, the second sensor probe, the third sensor probe, and the fourth sensor probe may each be an inductive sensor probe including a core and a coil.

The first bearing and/or the second bearing may be a magnetic suspension bearing.

One or more embodiments of this application further provide a motor including the bearing device according to any one of the above technical solutions.

One or more embodiments of this application further provide a compressor including the bearing device according to any one of the above technical solutions.

### BRIEF DESCRIPTION OF THE SEVERAL VIEWS OF THE DRAWINGS

Certain exemplary embodiments will now be described in greater detail by way of example only and with reference to the accompanying drawings in which:
Fig. 1 is a schematic structural diagram of a rotating shaft of a bearing device at a balanced position;
Fig. 2 is a schematic structural diagram showing a case where the rotating shaft of the bearing device radially deviates;
Fig. 3 is a schematic structural diagram of a bearing device;
Fig. 4 is a schematic structural diagram of a bearing device;
Fig. 5 is a schematic plan view of a sensor disc;
Fig. 6 is a schematic structural diagram of a motor; and
Fig. 7 is a schematic structural diagram of a compressor.

Reference numerals: bearing device 1, rotating shaft 101, first bearing 102, second bearing 103, thrust disc 104, sensor disc 105, first displacement sensor 106, second displacement sensor 107, first sensor probe 1051, second sensor probe 1052, third sensor probe 1053, fourth sensor probe 1054, first excitation source module 108, second excitation source module 109, excitation source module 110, motor 2, compressor 3.

### DETAILED DESCRIPTION OF THE DISCLOSURE

It should be noted that working principles, features, advantages, and the like of a bearing device according to this application will be explained below by way of embodiments. However, it should be understood that all descriptions are only given for exemplification and therefore these embodiments should not be understood as forming any limitation on this application.

In addition, for any single technical feature described or implicit in some embodiments mentioned herein, or any single technical feature shown or implicit in the drawings, the present application still allows any combination or deletion between these technical features (or their equivalents) without any technical obstacles, thereby obtaining more other embodiments of the present application that may not be directly mentioned herein.

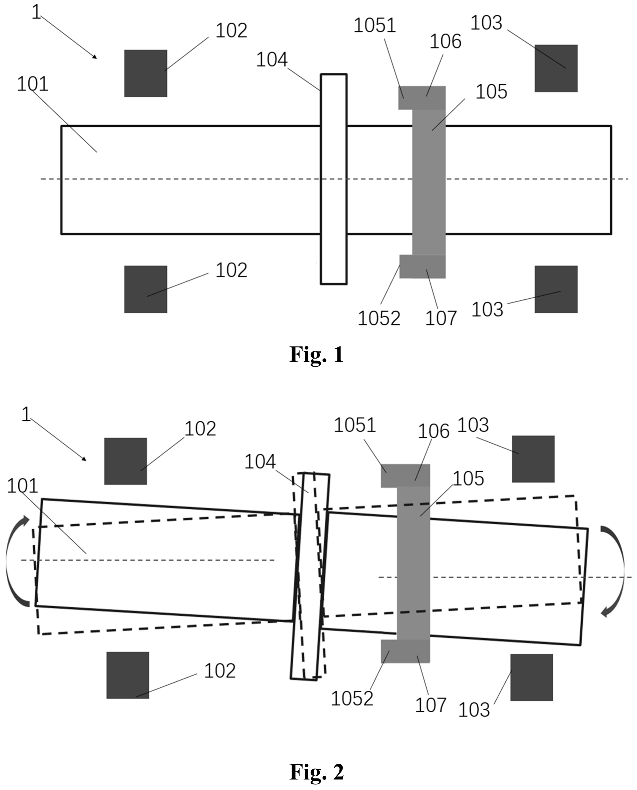

Fig. 1 is a schematic structural diagram of a rotating shaft 101 of a bearing device 1 according to one or more embodiments of this application at a balanced position. Referring to Fig. 1, the bearing device 1 according to one or more embodiments of the present application includes the rotating shaft 101, a first bearing 102, a second bearing 103, a thrust disc 104, a sensor disc 105, a first displacement sensor 106, a second displacement sensor 107, a first sensor probe 1051, and a second sensor probe 1052.

As shown in Fig. 1, the bearing device 1 mainly includes the first bearing 102, the second bearing 103, which are arranged parallel to each other, and the rotating shaft 101, and the first bearing 102 and the second bearing 103 are annular hollow structures and are respectively disposed around two ends of the rotating shaft 101. At the same time, inner diameters of the first bearing 102 and the second bearing 103 are controlled to be slightly larger than a diameter of the rotating shaft 101, so that when the bearing device 1 operates and the rotating shaft 101 is located at the balanced position (a position of the rotating shaft 101 shown in Fig. 1), there is no direct contact between the rotating shaft 101 and the first bearing 102 or the second bearing 103.

The thrust disc 104 is disposed between the first bearing 102 and the second bearing 103, is in direct contact with the rotating shaft 101, and is sleeved on and fixed to the rotating shaft 101, and during the rotation of the rotating shaft 101, the thrust disc 104 and the rotating shaft 101 rotate together without relative displacement. Between the thrust disc 104 and the first bearing 102 or the second bearing 103, the annular sensor disc 105 corresponding to the first bearing 102 or the second bearing 103 is further disposed around the rotating shaft 101, and the sensor disc 105 is not in direct contact with the rotating shaft 101, but is fixed on another component of the bearing device 1. The sensor disc 105 is further provided with the first displacement sensor 106 including the first sensor probe 1051 and the second displacement sensor 107 including the second sensor probe 1052, and the first sensor probe 1051 and the second sensor probe 1052 are symmetrical to a central axis of the rotating shaft 101 and are disposed on one side of the sensor disc 105 facing the thrust disc 104. The first displacement sensor 106 and the second displacement sensor 107 are optionally axial sensors parallel to the central axis of the rotating shaft 101, and detect whether the sensor disc 105 and the thrust disc 104 have a relative displacement by the first sensor probe 1051 and the second sensor probe 1052 disposed axially.

Fig. 2 is a schematic structural diagram showing a case where the rotating shaft 101 of the bearing device 1 according to one or more embodiments of this application radially deviates. Referring to Fig. 1 and Fig. 2, when the rotating shaft 101 is located at the balanced position (the position of the rotating shaft 101 shown in Fig. 1), the sensor disc 105 and the thrust disc 104 are parallel to each other. When the rotating shaft 101 radially deviates during rotation (that is, the central axis of the rotating shaft 101 is inclined from a normal position, and for example, deviates to a position of the rotating shaft 101 shown in Fig. 2), the thrust disc 104 deviates along with the deviation of the rotating shaft 101, but the sensor disc 105 is still maintained at an original position, and in this case, a parallel relationship between the thrust disc 104 and the sensor disc 105 is destroyed, resulting in the relative displacement therebetween.

Fig. 2 shows a situation where the rotating shaft 101 is inclined so that a distance between the first sensor probe 1051 and the thrust disc 104 is reduced. In this case, if the first sensor probe 1051 (or the second sensor probe 1052) detects that a distance between the thrust disc 104 and the sensor disc 105 is reduced, and the second sensor probe 1052 (or the first sensor probe 1051) detects that the distance between the thrust disc 104 and the sensor disc 105 is increased, it can be determined that one side of the rotating shaft 101 close to the sensor disc 105 is inclined toward the position of the second displacement sensor 107 (or the first displacement sensor 106).

Similarly, assuming that the first sensor probe 1051 (or the second sensor probe 1052) detects that the distance between the thrust disc 104 and the sensor disc 105 is increased, and the second sensor probe 1052 (or the first sensor probe 1051) detects that the distance between the thrust disc 104 and the sensor disc 105 is reduced, it can be determined that the side of the rotating shaft 101 close to the sensor disc 105 is inclined toward the position of the first displacement sensor 106 (or the second displacement sensor 107).

In one or more embodiments of this application, since a distance change value X1 between the thrust disc 104 and the sensor disc 105 in an axial direction of the position where the first sensor probe 1051 is located can be detected by the first sensor probe 1051, and at the same time, a distance change value X2 between the thrust disc 104 and the sensor disc 105 in an axial direction of the position where the second sensor probe 1052 is located can be detected by the second sensor probe 1052, and a degree of inclination of a cross-sectional position of the thrust disc 104 can be detected according to the distance change value X1 and the distance change value X2, thereby determining whether the rotating shaft 101 deviates from the balanced position and determining a degree of deviation or inclination.

In one or more embodiments, the axial sensor is used instead of a radial sensor that directly detects radial displacement of the rotating shaft 101, and the degree of inclination of the cross-sectional position of the thrust disc 104 can be detected, thereby accurately determining the degree of inclination of the rotating shaft 101 fixedly connected to the thrust disc 104.

At the same time, the sensors are arranged axially instead of radially, which reduces a space occupied by the sensors in the radial direction, and also reduces a possibility of an error in sensor detection caused by direct contact with the sensors when the rotating shaft 101 has large deviation. At the same time, by arranging the first sensor probe 1051 and the second sensor probe 1052 to be symmetrical to the central axis of the rotating shaft 101, detection results of the first sensor probe 1051 and the second sensor probe 1052 are combined to obtain the degree of deviation of the rotating shaft 101, which avoids an error that may occur when one displacement sensor or one sensor probe is used alone.

In an exemplary embodiment of this application, the first bearing 102 and/or the second bearing 103 is a magnetic suspension bearing.

In one or more embodiments, the magnetic suspension bearing is used as the first bearing 102 and/or the second bearing 103, so that there is no mechanical contact between the rotating shaft 101 and the first bearing 102 and between the rotating shaft 101 and the second bearing 103, lubricating oil is not required and wear of the rotating shaft 101 or the first bearing 102 or the second bearing 103 is reduced, and a service life of the bearing device 1 is prolonged. At the same time, since there is no mechanical contact between the rotating shaft 101 and the first bearing 102 and between the rotating shaft 101 and the second bearing 103 during the operation of the bearing device 1, noise that may be generated during the operation of the bearing device 1 is reduced. When the first displacement sensor 106 and the second displacement sensor 107 detect that the rotating shaft 101 deviates, a magnetic force of the first bearing 102 or the second bearing 103 can be adjusted by controlling a current of the first bearing 102 or the second bearing 103, so that the rotating shaft 101 can return to the balanced position. This avoids a problem that if a mechanical bearing is used, the bearing device 1 needs to be greatly adjusted when the rotating shaft 101 deviates.

Elements denoted by the same names and symbols as those in the bearing device 1 according to a second embodiment of this application and the bearing device 1 in one or more embodiments of this application represent identical elements, and descriptions thereof are omitted here.

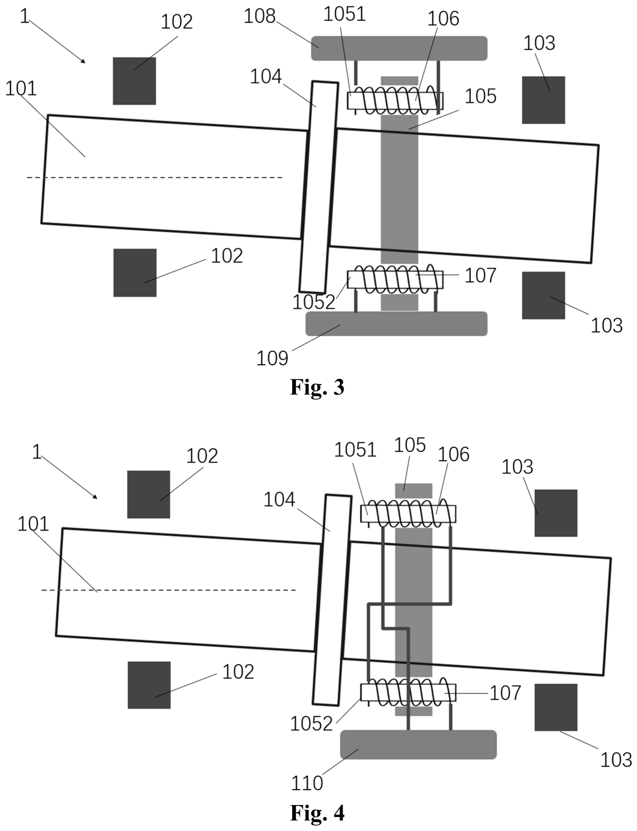

Fig. 3 is a schematic structural diagram of the bearing device 1 according to the second embodiment of this application. As shown in Fig. 3, the bearing device 1 according to the second embodiment of this application further includes a first excitation source module 108 and a second excitation source module 109.

The first excitation source module 108 is electrically connected to the first sensor probe 1051, and the second excitation source module 109 is electrically connected to the second sensor probe 1052. That is, the two sensor probes are connected in parallel, and the first sensor probe 1051 and the second sensor probe 1052 work independently and each has an independent excitation source module.

Since the first sensor probe 1051 and the second sensor probe 1052 are connected in parallel and work independently, the first sensor probe 1051 and the second sensor probe 1052 need to be calibrated and linearized respectively before use to make accuracies thereof consistent. By electrically connecting the first excitation source module 108 to the first sensor probe 1051 and electrically connecting the second excitation source module 109 to the second sensor probe 1052, first displacement data detected by the first sensor probe 1051 (that is, the distance change value X1 between the thrust disc 104 and the sensor disc 105 corresponding to the position of the first sensor probe 1051) and second displacement data detected by the second sensor probe 1052 (that is, the distance change value X2 between the thrust disc 104 and the sensor disc 105 corresponding to the position of the second sensor probe 1052) are respectively obtained, and then an arithmetic average value of the first displacement data and the second displacement data is calculated, the calculated result is used as actual deviation or inclination data of the rotating shaft 101, and the position of the rotating shaft 101 is adjusted according to the result.

In one or more embodiments, the first sensor probe 1051 and the second sensor probe 1052 work independently by parallel connection and record the first displacement data and the second displacement data respectively, and then the actual displacement data is calculated based on the first displacement data and the second displacement data, and the first sensor probe 1051 and the second sensor probe 1052 do not affect each other, which can improve the accuracy of the results output by the first displacement sensor 106 and the second displacement sensor 107. At the same time, the magnetic forces of the first bearing 102 and the second bearing 103 can be controlled more flexibly according to the first displacement data and the second displacement data, so that the rotating shaft 101 quickly returns to the balanced position.

As an exemplary embodiment of this application, the first excitation source module 108 and the first sensor probe 1051 are electrically connected by a coaxial cable, and the second excitation source module 109 and the second sensor probe 1052 are electrically connected by a coaxial cable.

The coaxial cable is a widely used cable type, is mainly used for signal transmission, and mainly includes, from inside to outside, a central conductor responsible for signal transmission, an insulating layer for preventing signal leakage, an outer conductor for preventing external electromagnetic interference, and an outer sheath for providing protection. A signal is transmitted in the central conductor of the coaxial cable, while the outer conductor serves as a signal return path and shields external interference. The connection by a coaxial cable reduces external signal interference to some extent and improves signal stability and transmission efficiency.

It should be noted that a specific model and specification of the coaxial cable are not limited in some embodiments of this application, and different coaxial cables are selected based on different transmission distances, signal frequencies, environmental conditions, and the like, to set optimal signal transmission performance, which should be included in the protection scope of this application.

Elements denoted by the same names and symbols as those in the bearing device 1 according to a third embodiment of this application and the bearing device 1 in one or more embodiments of this application represent identical elements, and descriptions thereof are omitted here.

Fig. 4 is a schematic structural diagram of the bearing device 1 according to the third embodiment of this application. As shown in Fig. 4, there is a difference from the first embodiment that the bearing device 1 according to this application further includes an excitation source module 110, and the excitation source module 110 is electrically connected in series with the first sensor probe 1051 and the second sensor probe 1052.

In one or more embodiments, there is a difference from the parallel connection that by connecting the first sensor probe 1051 and the second sensor probe 1052 in series, since the first sensor probe 1051 and the second sensor probe 1052 are connected to the same excitation source module 110 at the same time, the accuracies are consistent with each other, and there is no need to calibrate and linearize the first sensor probe 1051 and the second sensor probe 1052 respectively before use, thereby making the operation easier. At the same time, the first displacement signal obtained by the first sensor probe 1051 and the second displacement signal obtained by the second sensor probe 1052 can be automatically compensated by hardware, and a compensated actual displacement signal is output without being calculated by software, so that the bearing device 1 can obtain an actual displacement signal of the rotating shaft 101 more quickly, and control the rotating shaft 101 to make adjustments in time. At the same time, the series connection is used instead of the parallel connection, so that the excitation source modules in the bearing device 1 are reduced, and the initial cost of the bearing device 1 is reduced.

As an exemplary embodiment of this application, the excitation source module 110 is electrically connected to the first sensor probe 1051 and the second sensor probe 1052 in series by a coaxial cable.

In one or more embodiments, the first sensor probe 1051, the second sensor probe 1052, and the excitation source module 110 are connected by the coaxial cable, so that external signal interference is reduced to some extent, and the signal stability and the transmission efficiency are improved. The first sensor probe 1051 and the second sensor probe 1052 are connected by a coaxial cable with excellent shielding performance, thereby avoiding a problem that connection lines between the first sensor probe 1051 and the second sensor probe 1052 are close, so that signals may affect each other, resulting in errors in the output actual displacement signal.

Elements denoted by the same names and symbols as those in the bearing device 1 according to a fourth embodiment of this application and the bearing device 1 in one or more embodiments of this application represent identical elements, and descriptions thereof are omitted here.

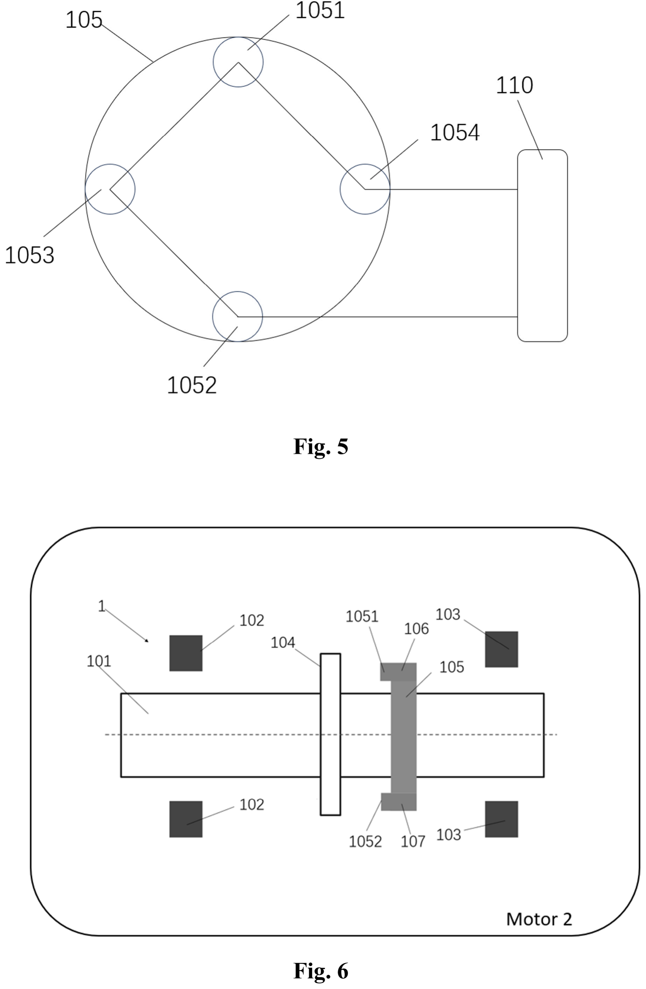

Fig. 5 is a schematic plan view of the sensor disc 105 according to the fourth embodiment of this application. As shown in Fig. 5, there is a difference from the above embodiment that the bearing device 1 according to this application further includes a third sensor probe 1053 and a fourth sensor probe 1054.

As shown in Fig. 5, the third sensor probe 1053 and the fourth sensor probe 1054 are disposed on the sensor disc 105, and the third sensor probe 1053 and the fourth sensor probe 1054 are disposed symmetrically with respect to the central axis of the rotating shaft 101 on one side of the sensor disc 105 facing the thrust disc 104. The excitation source module 110 is electrically connected to the first sensor probe 1051, the second sensor probe 1052, the third sensor probe 1053, and the fourth sensor probe 1054 in series, and optionally, the first sensor probe 1051, the second sensor probe 1052, the third sensor probe 1053, and the fourth sensor probe 1054 each are an inductive sensor probe including a core and a coil.

In one or more embodiments, the first sensor probe 1051, the second sensor probe 1052, the third sensor probe 1053, and the fourth sensor probe 1054 connected in series detect relative displacements at different positions between the thrust disc 104 and the sensor disc 105 together, and output actual displacement signals. Inclination data of the sectional position of the thrust disc 104 can be obtained by the first sensor probe 1051 and the second sensor probe 1052 for only one angle, and thus, by additionally providing the third sensor probe 1053 and the fourth sensor probe 1054, the inclination data of the sectional position of the thrust disc 104 can be obtained for more angles, so that displacement deviation data of the rotating shaft 101 in a plurality of directions can be obtained, and the rotating shaft 101 can be more accurately controlled to make adjustments.

As an exemplary embodiment of this application, the excitation source module 110 is electrically connected to the first sensor probe 1051, the second sensor probe 1052, the third sensor probe 1053, and the fourth sensor probe 1054 in series by a coaxial cable.

In one or more embodiments, the first sensor probe 1051, the second sensor probe 1052, the third sensor probe 1053, the fourth sensor probe 1054, and the excitation source module 110 are connected in series by the coaxial cable, so that external signal interference is reduced to some extent, and the signal stability and the transmission efficiency are improved. The first sensor probe 1051, the second sensor probe 1052, the third sensor probe 1053, and the fourth sensor probe 1054 are connected by a coaxial cable with excellent shielding performance, thereby avoiding a problem that connection lines between the first sensor probe 1051, the second sensor probe 1052, the third sensor probe 1053, and the fourth sensor probe 1054 are close, so that signals may affect each other, resulting in errors in the output actual displacement signal.

Although one or more embodiments are described by way of the first sensor probe 1051, the second sensor probe 1052, the third sensor probe 1053, and the fourth sensor probe 1054, this application is not limited thereto, and as long as 2n sensor probes are symmetrically disposed, it should be included in the protection scope of this application, where n optionally represents a positive integer not greater than 4.

As an exemplary embodiment of this application, 2n sensor probes are symmetrically disposed around the sensor disc 105 at the same distance, and if n represents 2, four sensor probes are arranged in a square. If n represents 3, six sensor probes are arranged in a regular hexagon. If n represents 4, eight sensor probes are arranged in a regular octagon.

It should be noted that, similar to the second embodiment or the third embodiment, in the sensor probes of this application, one excitation source module may be connected to the 2n sensor probes in series, an arithmetic average value of displacement deviation data detected by the 2n sensor probes is calculated, the calculated result is used as actual deviation or inclination data of the rotating shaft 101, and the position of the rotating shaft 101 is adjusted according to the result. Alternatively, a first excitation source module, a second excitation source module, a third excitation source module, ..., and a 2n-th excitation source module may be disposed corresponding to 2n sensor probes, so that each sensor probe is correspondingly connected to an independent excitation source module, and each sensor independently outputs displacement deviation data, which is automatically compensated by hardware, and a compensated actual displacement signal is output without being calculated by software, so that the bearing device 1 can obtain the actual displacement signal of the rotating shaft 101 more quickly, and control the rotating shaft 101 to make adjustments in time.

Fig. 6 is a schematic structural diagram of a motor according to one or more embodiments of this application. As shown in Fig.6, one or more embodiments of this application further provide a motor 2 including the bearing device 1 according to one or more embodiments.

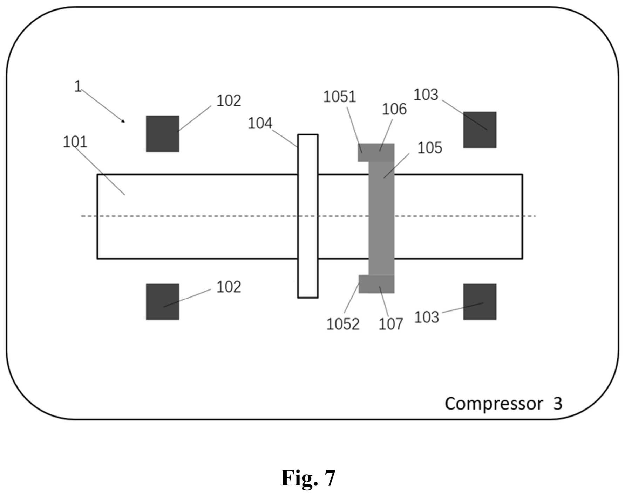

Fig. 7 is a schematic structural diagram of a compressor according to one or more embodiments of this application. As shown in Fig.7, one or more embodiments of this application further provide a compressor 3 including the bearing device 1 according to one or more embodiments.

## Claims

1. A bearing device (1) comprising:
a rotating shaft (101);
a first bearing (102) surrounding the rotating shaft;
a second bearing (103) surrounding the rotating shaft in parallel with the first bearing;
a thrust disc (104) sleeved on and fixed to the rotating shaft between the first bearing and the second bearing;
a sensor disc (105) disposed around the rotating shaft between the first bearing and the thrust disc or between the second bearing and the thrust disc;
a first displacement sensor (106) including a first sensor probe (1051) disposed on the sensor disc; and
a second displacement sensor (107) including a second sensor probe (1052) disposed on the sensor disc symmetrically with respect to the first sensor probe.

2. The bearing device (1) according to claim 1, further comprising:
a first excitation source module (108) electrically connected to the first sensor probe (1051); and
a second excitation source module (109) electrically connected to the second sensor probe (1052).

3. The bearing device (1) according to claim 1, further comprising:
an excitation source module (110) electrically connected in series with the first sensor probe (1051) and the second sensor probe (1052).

4. The bearing device (1) according to claim 3, further comprising:
a third sensor probe (1053) disposed on the sensor disc (105); and
a fourth sensor probe (1054) disposed on the sensor disc symmetrically with respect to the third sensor probe, wherein
the excitation source module (110) is electrically connected in series with the first sensor probe (1051), the second sensor probe (1052), the third sensor probe, and the fourth sensor probe.

5. The bearing device (1) according to claim 2, wherein
the first excitation source module (108) and the first sensor probe (1051) are electrically connected by a coaxial cable, and
the second excitation source module (109) and the second sensor probe (1052) are electrically connected by a coaxial cable.

6. The bearing device (1) according to claim 4, wherein
the excitation source module (110) is electrically connected in series with the first sensor probe (1051) and the second sensor probe (1052) by a coaxial cable, or the excitation source module is electrically connected in series with the first sensor probe, the second sensor probe, the third sensor probe (1053), and the fourth sensor probe (1054) by a coaxial cable.

7. The bearing device (1) according to any preceding claim, wherein
the first sensor probe (1051), the second sensor probe (1052), the third sensor probe (1053), and the fourth sensor probe (1054) each are an inductive sensor probe including a core and a coil.

8. The bearing device (1) according to any preceding claim, wherein
the first bearing (102) and/or the second bearing (103) is a magnetic suspension bearing.

9. A motor (2) comprising:
the bearing device (1) according to any preceding claim.

10. A compressor (3) comprising:
the bearing device (1) according to any of claims 1 to 9.
